## Europäisches Patentamt
## European Patent Office
## Office européen des brevets

(19)

(11) Veröffentlichungsnummer: **0 205 158 B1**

# EUROPÄISCHE PATENTSCHRIFT

(12)

(45) Veröffentlichungstag der Patentschrift:
24.01.90

(51) Int. Cl.⁴: **H03K 19/094**

(21) Anmeldenummer: 86107922.6

(22) Anmeldetag: 10.06.86

(54) Elektronischer Schalter.

(30) Priorität: 12.06.85 DE 3521090

(43) Veröffentlichungstag der Anmeldung:
17.12.86 Patentblatt 86/51

(45) Bekanntmachung des Hinweises auf die Patenterteilung:
24.01.90 Patentblatt 90/4

(84) Benannte Vertragsstaaten:
DE FR GB IT

(56) Entgegenhaltungen:
US-A- 3 823 330
US-A- 4 064 405

RCA APPLICATION NOTE ICAN-6218, Februar 1970,
Harrison, N.J., US; R.R. PAINTER: "Gate-oxide
protection circuit in RCA COS/MOS digital integrated
circuits"

(73) Patentinhaber: Siemens Aktiengesellschaft,
Wittelsbacherplatz 2, D-8000 München 2(DE)

(72) Erfinder: Einzinger, Josef, Dipl.-Ing., Am Weiher 21,
D-8044 Unterschleissheim(DE)
Erfinder: Fellinger, Christine, von Stauffenberg
Strasse 3, D-8025 Unterhaching(DE)
Erfinder: Leipold, Ludwig, Dipl.-Ing., Strassberger
Strasse 125, D-8000 München 40(DE)
Erfinder: Tihanyi, Jenö, Dr., Windeck 1 d,
D-8000 München 70(DE)
Erfinder: Weber, Roland, Dipl.-Ing., Ursulastrasse 5,
D-8000 München 40(DE)

## Beschreibung

Die Erfindung bezieht sich auf einen elektronischen Schalter mit den Merkmalen:

a) Die Drain-Source-Strecke eines ersten und eines zweiten MOSFET sind zwischen einem ersten und einem zweiten Versorgungsspannungspotential in Reihe geschaltet,

b) der erste und der zweite MOSFET sind Enhancement-FET und haben einander komplementäre Kanaltypen,

c) der erste und zweite MOSFET sind drainseitig miteinander verbunden,

d) der Verbindungspunkt beider MOSFET ist mit einer Ausgangsklemme verbunden,

e) Die Drain-Source-Strecke eines dritten MOSFET, der vom gleichen Kanaltyp wie der erste MOSFET ist, ist über einen Widerstand mit dem zweiten Versorgungsspannungspotential verbunden,

f) der Verbindungspunkt zwischen Widerstand und drittem MOSFET ist mit dem Gateanschluß des zweiten MOSFET verbunden,

g) der Gateanschluß des ersten MOSFET ist mit einer ersten von zwei Steuereingangsklemmen verbunden,

h) der Sourceanschluß des dritten MOSFET ist der ersten Eingangsklemme verbunden.

Ein elektronischer Schalter dieser Art ist bereits im US-Patent 4 064 405 beschrieben worden. Der erwähnte dritte MOSFET ist ein Enhancement-FET, der bei Anlegen einer Eingangsspannung leitend gesteuert wird. Es fließt damit ein Strom durch den dem Enhancement-FET in Reihe geschalteten Widerstand und eine Diode, die zwischen dem Gateanschluß und dem Sourceanschluß des zweiten MOSFET angeschlossen ist. In diesem Zustand muß daher die Steuerspannungsquelle einen Strom liefern.

Der Erfindung liegt die Aufgabe zugrunde, den elektronischen Schalter der bekannten Art so weiterzubilden, daß beim Anlegen einer Eingangsspannung kein wesentlicher Stromfluß auftritt.

Diese Aufgabe wird gelöst durch die folgenden Merkmale:

i) der dritte MOSFET ist ein Depletion-FET,

k) der Gateanschluß des dritten MOSFET ist mit dem Sourceanschluß des ersten MOSFET und mit der zweiten Eingangsklemme verbunden.

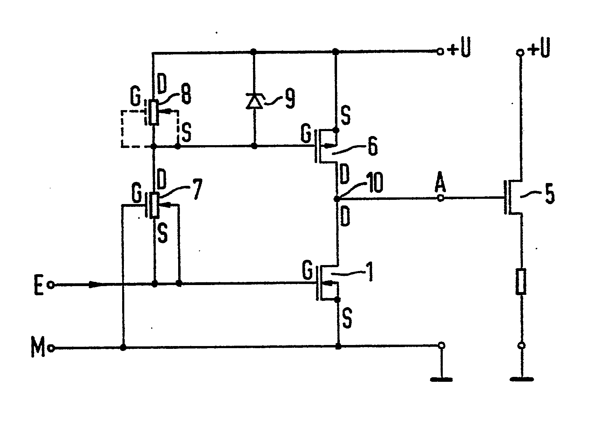

Die Erfindung wird anhand eines Ausführungsbeispiels in Verbindung mit der Figur näher erläutert. Weiterbildungen der Erfindung sind Gegenstand der Unteransprüche.

Der elektronische Schalter nach besteht aus zwei MOSFET 1 und 6, deren Drain-Source-Strecken in Reihe geschaltet sind. Soll der elektronische Schalter eine positive Spannung +U schalten, so ist der erste MOSFET 1 ein n-Kanal-FET. Der zweite MOSFET 6 ist dann ein p-Kanal-FET. Soll eine negative Spannung geschaltet werden, so ist der FET 1 ein p-Kanal-und der FET 6 n-Kanal-FET. Die FET 1 und 6 sind drainseitig zusammengeschaltet, der Verbindungspunkt 10 ist mit der Ausgangsklemme A verbunden. Der Gateanschluß des FET 1 liegt an der ersten Eingangsklemme E. Er ist außerdem mit dem Sourceanschluß eines Depletion-FET 7 verbunden, dessen Gateelektrode an der zweiten Eingangsklemme M bzw. Masse liegt. Der Drainanschluß des FET 7 liegt über einem Widerstand 8 an der Versorgungsspannung +U. Der Widerstand 8 kann, wie gestrichelt dargestellt, auch ein weiterer Depletion-FET sein, dessen Gateanschluß mit dem Sourceanschluß kurzgeschlossen ist. Dieser Transistor wirkt dann wie eine Stromquelle mit unendlich hohem Innenwiderstand.

Die Depletion-FET 7 und 8 haben n-leitende Kanäle. Soll eine negative Spannung geschaltet werden, so sind Depletion-FET mit p-Kanal zu verwenden.

Wird an die Eingangsklemme E, M ein Signal mit dem Pegel H von z. B. +5 V gelegt, so wird der FET 1 aufgesteuert und der Ausgang A liegt auf Massepotential. Der FET 7 erhält eine negative Gatevorspannung und wird gesperrt. Damit liegt am Drainanschluß des FET 7 und am Gateanschluß des FET 6 hohes Potential an, wodurch der FET 6 gesperrt wird. Der elektronische Schalter ist damit gesperrt, es fließt weder Laststrom zum Verbraucher 5 noch ein Querstrom durch den Widerstand 8 und den FET 7.

Wird an den Eingang E, M ein Signal mit dem Pegel L von z. B. 0 V gelegt, so wird der FET 1 gesperrt und der Depletion-FET 7 erhält die Gate-Source-Spannung 0 V. Er wird dann eingeschaltet und es kann ein Strom durch den Widerstand 8 und den FET 7 fließen. Am Gateanschluß des p-Kanal-FET 6 stellt sich dann ein Potential ein, das durch das Spannungsteilerverhältnis zwischen Widerstand 8 und FET 7 bestimmt ist. Diese Spannung ist positiv und bleibt konstant. Der Sourceanschluß des FET 6 liegt an einer konstanten Spannung. Der elektronische Schalter kann damit sehr schnell einschalten und eine an der Ausgangsklemme A liegende kapazitive Last, z. B. die Gate-Kapazität eines Leistungs-FET, wird sehr schnell aufgeladen.

Die Gate-Source-Strecke des MOSFET 6 kann gegenüber Spannung auf übliche Weise, z. B. durch eine Zenerdiode 9, geschützt werden.

## Patentansprüche

1. Elektronischer Schalter mit den Merkmalen:

a) Die Drain-Source-Strecke eines ersten und eines zweiten MOSFET (1, 6) sind zwischen einem ersten und einem zweiten Versorgungsspannungspotential in Reihe geschaltet,

b) der erste und der zweite MOSFET (1, 6) sind Enhancement-FET und haben einander komplementäre Kanaltypen,

c) der erste und zweite MOSFET sind drainseitig miteinander verbunden,

d) der Verbindungspunkt beider MOSFET ist mit einer Ausgangsklemme (A) verbunden,

e) die Drain-Source-Strecke eines dritten MOSFET (7), der vom gleichen Kanaltyp wie der erste MOSFET (1) ist, ist über einen Widerstand (8) mit dem zweiten Versorgungsspannungspotential (+V) verbunden,

f) der Verbindungspunkt zwischen Widerstand und drittem MOSFET ist mit dem Gateanschluß des zweiten MOSFET (6) verbunden,

g) der Gateanschluß des ersten MOSFET (1) ist mit einer ersten von zwei Steuereingangsklemmen (E) verbunden,

h) der Sourceanschluß des dritten MOSFET (7) ist mit der ersten Eingangsklemme (E) verbunden, gekennzeichnet durch die Merkmale:

i) der dritte MOSFET (7) ist ein Depletion-FET,

k) der Gateanschluß des dritten MOSFET (7) ist mit dem Sourceanschluß des ersten MOSFET (1) und mit der zweiten Eingangsklemme (M) verbunden.

## Claims

1. Electronic switch having the features:

(a) the drain-to-source path of a first and of a second MOSFET (1, 6) are series-connected between a first and a second supply voltage potential,

(b) the first and the second MOSFET (1, 6) are enhancement FETs and have channel types which complement one another,

(c) the first and second MOSFET are interconnected at the drain side,

(d) the junction of both MOSFETs is connected to an output terminal (A),

(e) the drain-to-source path of a third MOSET (7), which has the same channel type as the first MOSFET (1), is connected via a resistor (8) to the second supply voltage potential (+U),

(f) the junction between resistor and third MOSFET is connected to the gate terminal of the second MOSFET (6),

(g) the gate terminal of the first MOSFET (1) is connected to a first of two control input terminals (E),

(h) the source terminal of the third MOSFET (7) is connected to the first input terminal (E), characterized by the features:

(i) the third MOSFET (7) is a depletion FET,

(k) the gate terminal of the third MOSFET (7) is connected to the source therminal of the first MOSFET (1) and to the second input terminal (M).

## Revendications

1. Commutateur électronique du type dans lequel:

a) les pistes drain-source d'un premier et d'un second MOSFET (1, 6) sont montées en série entre un premier et un second potentiel de tension d'alimentation,

b) le premier et le second MOSFET (1, 6) sont des transistors à effet de champ du type à enrichissement et possèdent des types de canaux complémentaires entre eux,

c) le premier et le second MOSFET sont reliés entre eux côté drain,

d) le point de liaison des deux MOSFET est relié à une borne de sortie (A),

e) la piste drain-source d'un troisième MOSFET (7) qui est du même type de canal que le premier MOSFET (1), est reliée par l'intermédiaire d'une résistance (8) au second potentiel de source d'alimentation,

f) le point de liaison entre la résistance et le troisième MOSFET est relié avec la borne de grille du second MOSFET (6),

g) la borne de grille du premier MOSFET (1) est reliée avec une première des deux bornes d'entrée de commande (E),

h) la borne de source du troisième MOSFET (7) est reliée avec la première borne d'entrée (E), caractérisé par les particularités suivantes:

i) le troisième MOSFET (7) est un transistor à effet de champ à déplétion,

k) la borne de grille du troisième MOSFET (7) est reliée à la borne de source du premier MOSFET (1) et à la seconde borne d'entrée (M).